# EUROPEAN PATENT SPECIFICATION

(11) **EP 2 075 839 B1**
(45) Date of publication and mention of the grant of the patent: **11.05.2011**
(21) Application number: 07827913.0
(22) Date of filing: 18.10.2007
(51) Int. Cl.: H01L 21/66, H01L 23/544, G01R 31/26, H01L 27/12

(54) **METHOD FOR EVALUATING SOI WAFER**
VERFAHREN ZUM EVALUIEREN EINES SOI-WAFERS
PROCEDE D'EVALUATION D'UNE TRANCHE DE SOI

(30) Priority: 20.10.2006 JP 2006286080
(43) Date of publication of application: 01.07.2009
(73) Proprietor: Shin-Etsu Handotai Co., Ltd., Tokyo 100-0004 (JP)
(72) Inventor: OHTSUKI, Tsuyoshi, Annaka-shi Gunma 379-0196 (JP); YOSHIDA, Kazuhiko, Chikuma-shi Nagano 387-8555 (JP)
(74) Representative: Wibbelmann, Jobst
(86) International application number: PCT/JP2007/001134
(87) International publication number: WO 2008/047478

(56) References cited:
- JP-A- 08 255 884
- JP-A- 11 054 584
- ZAVRACKY P ET AL: "High quality SOI material produced using isolated silicon epitaxy" 19881003; 19881003 - 19881005, 3 October 1988 (1988-10-03), page 21, XP010079150
- PELELLA M M ET AL: "A Novel Self-Aligned Substrate-Diode Structure for SOI Technologies" SOI CONFERENCE, 2005. PROCEEDINGS. 2005 IEEE INTERNATIONAL HONOLULU, HI, USA 03-06 OCT. 2005, PISCATAWAY, NJ, USA,IEEE, 3 October 2005 (2005-10-03), pages 169-170, XP010866602 ISBN: 9780780392120
- KUBOTA H; NAGANO H; SUGAMOTO J; MATSUSHITA H; MOMOSE M; NITTA S;SAMATA S; TSUCHIYA N: "Use of diode diagnostics for silicon wafer quality characterization;effect of COP on pn junction leakage" HIGH PURITY SILICON VI. PROCEEDINGS OF THE SIXTH INTERNATIONALSYMPOSIUM (ELECTROCHEMICAL SOCIETY PROCEEDINGS VOL. 2000-17) (SPIEVOL.4218)- 2000- ELECTROCHEM. SOC- PENNINGTON, NJ, USA, vol. 2000-17, 2000, pages 634-645, XPxp8113321 Pennington, NJ, USA ISBN: 1566772842
- AVSET B S: "Evaluation of silicon diodes made on a variety of high-resistivity phosphorus-doped substrates" NUCLEAR INSTRUMENTS & METHODS IN PHYSICS RESEARCH, SECTION - A:ACCELERATORS, SPECTROMETERS, DETECTORS AND ASSOCIATED EQUIPMENT, ELSEVIER, AMSTERDAM, NL, vol. 385, no. 1, 11 January 1997 (1997-01-11), pages 137-144, XP004034074 ISSN: 0168-9002
- KUBOTA H. ET AL: 'Use of diode diagnostics for silicon wafer quality characterization; effect of COP on pn junction leakage' HIGH PURITY SILICON VI : PROCEEDINGS OF THE SIXTH INTERNATIONAL SYMPOSIUM, ELECTROCHEMICAL SOCIETY, US vol. 4218, 01 January 2000, pages 634 - 645, XP008113321 ISBN: 978-1-56677-284-6

## Description

### TECHNICAL FIELD

The present invention relates to a method for evaluating an SOI wafer.

### BACKGROUND ART

In recent years, an SOI wafer having an SOI structure having a silicon active layer formed on a silicon oxide film having electrical insulating properties particularly attracts attention as a high-performance LSI wafer for an electronic device since this SOI wafer is superior in high-speed properties of a device, a low-power consumption properties, high dielectric breakdown voltage characteristics, environment resistance, and others. That is because a buried oxide film (which may be referred to as a BOX film thereinafter) as an insulator is present between a base wafer and the silicon active layer (which will be also referred to as an SOI layer hereinafter) in the SOI wafer, and hence an electronic device formed on the SOI layer has a great advantage of a high breakdown voltage and a low soft error ratio by α-ray.

Further, in a thin-film SOI wafer in which an SOI layer has a thickness that is equal to or below 1 µm, since a PN junction area of a source and a drain can be reduced when an MOS (Metal Oxide Semiconductor) semiconductor device formed on the SOI layer is operated as complete depletion type, a parasitic capacitance can be reduced, and a speed for driving the device can be increased. Moreover, since a capacitance of the BOX film that serves as an insulator layer becomes in series with a depletion layer capacitance formed immediately below a gate oxide film, the depletion layer capacitance is substantially reduced, thereby a lower power consumption can be realized.

Furthermore, an SOI wafer having a higher quality is recently demanded to realize further fineness and higher performance of an electronic device. Therefore, evaluating an SOI layer quality of the SOI wafer is actively performed. As a technique of this SOI wafer quality evaluation, an MOS (Metal Oxide Semiconductor) structure is formed on a front surface of an SOI layer, and a voltage is applied to an electrode portion thereof to evaluate a quality of the SOI layer.
However, the above-explained method enables evaluating a quality of the front surface of the SOI layer, but it is incomplete as evaluation of the inside of the SOI layer.

On the other hand, as an evaluation method for an SOI layer and a BOX interface using a mercury probe, a Pseudo MOS FET method targeting an SOI wafer for evaluation is proposed (see, e.g., Japanese Unexamined Patent Publication (Kokai) No. 2001-60676, Japanese Unexamined Patent Publication (Kokai) No. 2001-267384, S. Cristoleveanu et al., "A Review of the Pseudo-MOS Transistor in SOI Wafers: Operation, Parameter Extraction, and Applications" IEEE Trans. Electron Dev, 47 1018 (2000), and H. J. Hovel, "Si film electrical characterization in SOI substrates by HgFET technique" Solid-State Electronics, 47, 1311 (2003)). According to this technique, an interface state density on an interface between the SOI layer and the BOX film or electrical characteristics of the SOI wafer can be accurately and simply measured.

According to this method, needle probes or mercury probes as evaluation electrodes are directly brought into contact with an SOI layer side of an SOI wafer forming a pseudo MOS structure, and these are determined as a source electrode and a drain electrode. Further, a back surface of the SOI wafer, i.e., a back surface of a base wafer of the SOI wafer is subjected to vacuum contact with respect to a stage that is also used as an electrode, or the wafer back surface is brought into contact with a needle to function as a gate electrode, and a voltage is applied to a space between these electrodes, thereby various electrical characteristics can be obtained.
In this evaluation method, although the interface between the SOI layer and the BOX film can be evaluated, evaluation of the inside of the SOI layer is incomplete.

As explained above, a surface layer of the SOI layer and an SOI/BOX interface can be evaluated. However, a recent SOI application range keeps expanding, and a quality evaluation method for the SOI layer itself is demanded.

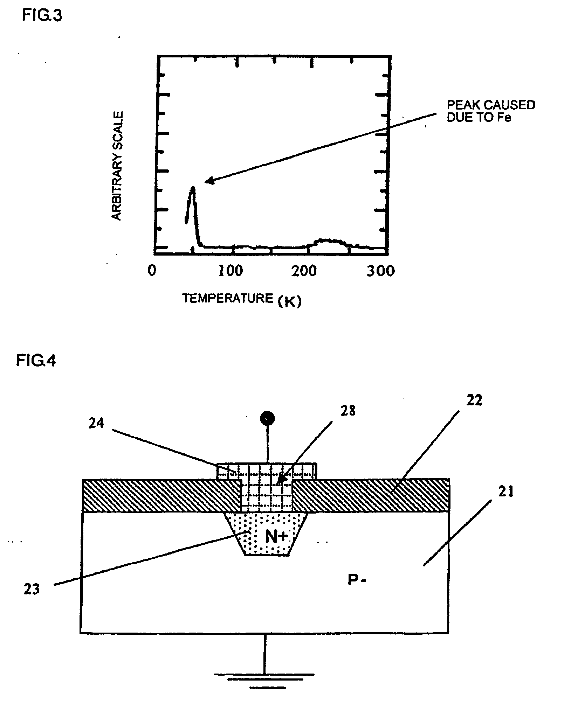

Here, as a characteristic evaluation method in, e.g., a polished wafer (PW) or an epitaxial wafer (EPW), a general technique using junction leakage current characteristics will now be explained. FIG. 4 is an explanatory view for explaining an example of this conventional evaluation method for, e.g., a PW. Here, a polished silicon wafer 21, which is of a P type, will be taken as an example to be explained.

As shown in FIG. 4, an oxide film 22 is first formed on a front surface of the silicon wafer 21, and then a part of the oxide film 22 placed on the front surface of a predetermined region of the silicon wafer 21 that is to be evaluated is removed to open a window. Moreover, a dopant having a conductivity type (N type in this example) different from a conductivity type (e.g., P type) of a semiconductor as an evaluation target is diffused through this window 28 to form a diffusion layer 23. Additionally, a heat treatment or the like is performed, thereby forming a PN junction in the silicon wafer 21. Then, an electrode 24 is formed on the diffusion layer 23, a back surface side of the silicon wafer 21 is determined as a GND, a reverse bias is applied to the electrode 24 to form a depletion layer in the silicon wafer 21, and a leakage current (a leak current) is measured. Since the leak current is increased if a defect is present in this depletion region, the inside of the silicon wafer 21 can be evaluated based on a measured intensity of the leak current.

However, in the above-explained highly demanded SOI layer in recent years, since the BOX film as an insulator layer is present as different from, e.g., a PW, simply applying the technique using junction leakage current characteristics adopted in, e.g., a conventional PW is difficult when evaluating this SOI wafer, and evaluating the inside of an active layer of the SOI wafer is difficult.
Furthermore, actually forming a device to perform evaluation requires a long time until a result is obtained, and feedback to a wafer manufacturing process also takes time, which is not efficient.

ZAVRACKY P ET AL: "High quality SOI material produced using isolated silicon epitaxy" 19881003; 19881003 - 19881005, 3 October 1988, page 21 discloses the electrical characterization of Isolated Silicon Epitaxy films by channel leakage current measurement performed on MOS transistors, junction leakage measurement in lateral pn diodes and DLTS measurements.

KUBOTA H; NAGANO H; SUGAMOTO J; MATSUSHITA H; MOMOSE M; NITTA S;SAMATA S; TSUCHIYA N: "Use of diode diagnostics for silicon wafer quality characterization; effect of COP on pn junction leakage" HIGH PURITY SILICON VI. PROCEEDINGS OF THE SIXTH INTERNATIONALSYMPOSIUM (ELECTROCHEMICAL SOCIETY PROCEEDINGS VOL. 2000-17) (SPIEVOL 4218)- 2000-ELECTROCHEM. SOC- PENNINGTON, NJ, USA, vol. 2000-17, 2000, pages 634-645, Pennington, NJ, USA ISBN: 1566772842 discloses a test structure for pn junction leakage measurements for silicon wafer characterization.

### DISCLOSURE OF INVENTION

In view of the above-explained problems, it is an object of the present invention to provide a method according to claim 1.

To achieve this object, according to the present invention, there is provided a method for evaluating an SOI wafer, comprising at least: forming an oxide film on a front surface of an SOI wafer; partially removing the oxide film to form windows at two positions; diffusing a dopant having a conductivity type different from a conductivity type of a semiconductor as an evaluation target through the windows at the two positions and forming diffused portions in the semiconductor as the evaluation target to form PN junctions; and performing leakage current measurement and/or DLTS measurement in a part between the two diffused portions to evaluate the SOI wafer.

As explained above, at least an oxide film is first formed on a front surface of an SOI wafer, then windows are formed at two positions, a dopant having a conductivity type different from a conductivity type of a semiconductor as an evaluation target is diffused through these windows, and diffused portions are formed in the semiconductor as the evaluation target to form PN junctions. Further, leakage current measurement and/or DLTS measurement is carried out between these two diffused portions, thereby the SOI wafer can be evaluated.
That is, the leakage current measurement and/or DLTS measurement can be performed in the semiconductor as the evaluation target based on the simple structure and the simple process alone where the two diffused portions and the two PN junctions are formed by using the oxide film as a mask, thus the inside of the SOI wafer can be evaluated. Therefore, the evaluation does not require a lot of labor or a long time, and the SOI wafer can be very simply and efficiently evaluated.

As explained above, when evaluating the SOI layer in the SOI wafer, since a BOX film is present in the SOI , wafer, simply applying a conventional evaluation method using, e.g., leakage current measurement that is performed in a PW or an EPW to carry out evaluation is difficult, and a long time is required to evaluate a quality of the SOI wafer as an evaluation target in evaluation after fabrication of a device, which is inefficient.
However, the method for evaluating an SOI wafer according to the present invention can readily evaluate the inside of the SOI layer without purposely forming a device. Both a time and a cost required for evaluation can be reduced, which is efficient.

According to the present invention, the SOI wafer, especially the inside of the SOI layer in the SOI wafer can be evaluated. Additionally, forming a simple PN junctions structure and performing leakage current measurement and/or DLTS measurement alone can suffice, and hence evaluation can be very efficiently performed without taking labor or a time.

### BRIEF DESCRIPTION OF DRAWINGS

FIG. 1 is an explanatory view for explaining a method for evaluating an SOI wafer according to the present invention;
FIG. 2 is a graph showing a measurement result of Example 1;
FIG. 3 is a graph showing a measurement result of Example 2; and
FIG. 4 is an explanatory view for explaining a conventional evaluation method when evaluating a PW or a EPW.

### BEST MODE FOR CARRYING OUT THE INVENTION

Although an embodiment according to the present invention will now be explained hereinafter, the present invention is not restricted thereto.
As explained above, when evaluating, e.g., a PW or an EPW, a dopant having a conductivity type different from a conductivity type of a semiconductor as an evaluation target is diffused in a semiconductor wafer as an evaluation target to form a diffusion layer, a PN junction is formed, then junction leakage current measurement or DLTS measurement is carried out, and characteristics of the semiconductor wafer are evaluated based on, e.g., a magnitude of a measured value.

However, when the semiconductor wafer as the evaluation target is as SOI wafer, since a wafer back surface side cannot be determined as a GND because of presence of a BOX film, the above evaluation method adopted with respect to the PW or the EPW cannot be simply applied to the SOI wafer, any other conventional evaluation method is a method for evaluating a surface layer of an SOI layer and an SOI/BOX interface, and evaluating the inside of the SOI layer in the SOI wafer is difficult.

Thus, as a result of repeatedly and keenly conducting studies by the present inventors, they discovered that the inside of a semiconductor can be evaluated by a method of at least diffusing a dopant having a conductivity type different from a conductivity type of the semiconductor as an evaluation target into the semiconductor as the evaluation target to form diffused portions at two positions and performing leakage current measurement and/or DLTS measurement between the diffused portions at the two positions to evaluate the semiconductor. The present inventors found that such an evaluation method enables readily evaluating the inside of the semiconductor as the evaluation target is an SOI wafer, thereby bringing the present invention to completion.

Although the method for evaluating an SOI wafer according to the present invention will now be explained hereinafter in detail with reference to the drawings, the present invention is not restricted thereto.

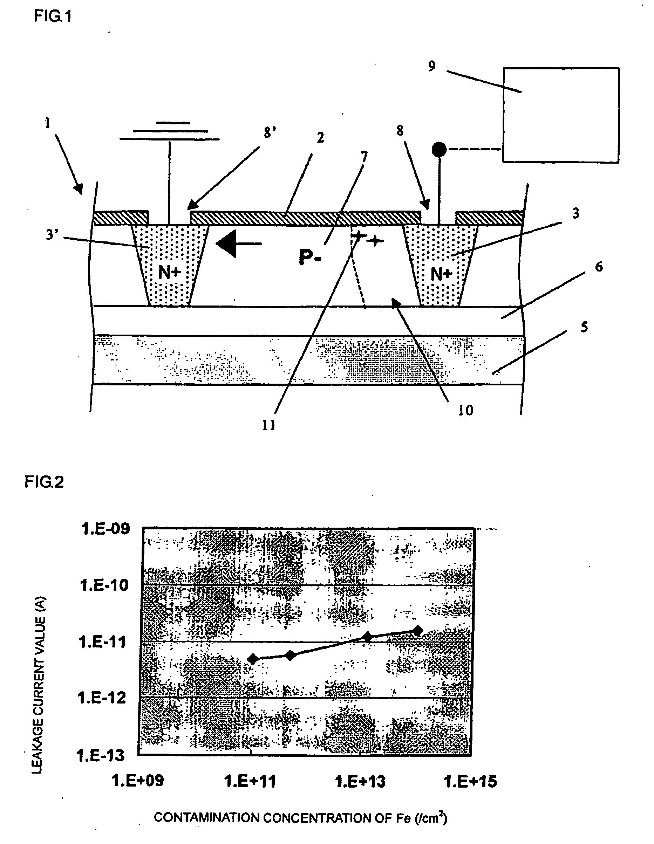

FIG. 1 is an explanatory view for explaining the method for evaluating an SOI wafer according to the present invention.
It is to be noted that an example where each of formation of windows and formation of diffused portions is carried out at two positions will be described hereinafter to simplify the explanation, but the number of such positions is not restricted two, performing formation in at least two positions can suffice, and formation of windows or diffused portions may be performed at more positions. Appropriately selecting two from these positions can suffice.

First, as shown in FIG. 1, an SOI wafer as an evaluation target in this example, an SOI wafer 1: a base wafer 5, a BOX film 6, and an SOI layer 7) in the evaluation method according to the present invention will be explained.

Further, when performing leakage current measurement and/or DLTS measurement, as shown in FIG. 1, two diffused portions (diffused portions 3 and 3') are formed in the semiconductor as the evaluation target, i.e., the SOI layer 7 in this example. These diffused portions 3 and 3' are formed by diffusing into the SOI layer 7 a dopant having a conductivity type different from a conductivity type of the SOI layer 7 through windows 8 and 8' opened in an oxide film 2 with the oxide film 2 formed on a front surface of the SOI wafer 1 being used as a mask, and PN junctions are respectively formed based on these portions.

Furthermore, although these diffused portions 3 and 3' are directly in contact with a probe in FIG. 1, electrodes may be of course formed on the diffused portions 3 and 3'. For example, presence/absence of the electrodes may be determined in accordance with a concentration of the dopant on front surfaces of the diffused portions 3 and 3'.

Moreover, a measuring instrument 9 used to perform leakage current measurement or DLTS measurement when carrying out the evaluation method according to the present invention is not restricted in particular, and the same instrument as that used in the conventional technology may be adopted. For example, as a measuring instrument for a leakage current, a prober and a tester taking a noise countermeasure can suffice. However, an instrument enabling measurement of the fA order is desirable in order to grasp a leak level.
Additionally, as a measuring instrument for DLTS measurement, using a generally commercially available instrument can suffice.

A procedure of the evaluation method according to the present invention will now be explained.
An SOI wafer as an evaluation target is first prepared.
Further an SOI wafer in which polished surfaces of two mirror-polished wafers having a silicon oxide film formed on at least one silicon wafer surface are bonded to each other, a heat treatment is carried out, and then a thickness of one wafer is reduced by grinding and polishing to be thin film may be adopted, or an SOI wafer in which hydrogen is ion-implanted into one mirror-polished wafer in advance, then polished surfaces of two mirror-polished wafers are bonded to each other, one wafer is delaminated at a hydrogen ion implanted layer by a subsequent heat treatment to form an SOI structure, and then a surface of a thin film serving as an SOI layer may be polished may be adopted. Furthermore, an SIMOX (Separated Implanted Oxide) wafer fabricated by ion-implanting oxygen into one mirror-polished wafer and then performing a high-temperature heat treatment may be adopted.

Appropriately evaluating the inside of an SOI layer is difficult in the past. However, the evaluation method according to the present invention enables easily and appropriately evaluating the inside of an SOI layer. Therefore, this evaluation method is particularly effective for evaluation of an SOI wafer.

Moreover, after the SOI wafer to be evaluated, i.e., the SOI wafer 1 in this example is prepared as explained above, the oxide film 2 is first formed on a front surface of this SOI wafer 1.
This oxide film 2 functions as a mask at a subsequent step of diffusing dopant. For example, a thermal oxide film may be formed, or a CVD oxide film may be deposited.

Although a thickness of the oxide film 2 is not restricted in particular, a thickness enabling masking a dopant that is subsequently diffused based on, e.g., implantation can suffice, and adopting a thickness equal to or above 500 nm is preferable. That is because, when such a thickness is adopted, diffusion of the dopant in the oxide film can be further effectively suppressed even when, e.g., glass deposition is used for diffusion of the dopant.
In case of forming the thick oxide film, forming the oxide film 2 based on the CVD method is preferable when the SOI layer 7 is thin (<100 nm).
An appropriate method for forming the oxide film 2 can be appropriately determined each time depending on a thickness of the SOI layer 7 or various conditions.

Then, this oxide film 2 is partially removed to form windows 8 and 8' for dopant diffusion.
For example, a pattern for forming windows in the oxide film 2 is formed in a resist based on photolithography, and this pattern is used as a mask to remove the oxide film at positions of the windows 8 and 8'.
Etching of the oxide film 2 may be dry etching or wet etching based on HF. In case of dry etching, a finer pattern can be processed. On the other hand, wet etching can avoid occurrence of a plasma damage.
Such a process of forming windows in the oxide film 2 can be performed by an appropriate method in accordance with respective conditions.

Additionally, when forming windows in the oxide film 2 is completed, a dopant is diffused.
A dopant having a conductivity type different from that of the semiconductor (the SOI layer 7 in this example) to be evaluated is diffused into the SOI layer 7 through the windows 8 and 8', and an annealing process is performed to form PN junctions. This diffusion can be carried out by using various techniques, e.g., ion implantation, glass deposition, or coating diffusion, and a diffusion method is not restricted in particular.
At this time, a diffusion length may be set to reach a BOX film, or it may be set to a depth where evaluation should be performed while considering spread of a depletion layer (which varies depending on a resistivity of the SOI layer).

Since a PN junction depth is dependent on annealing conditions, the junction depth can be adjusted by, e.g., conducting a preliminary experiment in advance and adjusting a time so that a desired depth can be provided.
Further, when the outermost surface concentration after diffusion is set to be a high concentration that is approximately, e.g., 1E20/cm³, there can be obtained an advantage that the outermost diffusion layer can be used as an electrode as it is without forming electrodes for leakage current measurement and/or DLTS measurement that is performed at a subsequent step. However, electrodes may be of course formed on the diffused portions 3 and 3'.

The diffused portions and the PN junctions are formed in the SOI wafer 1 based on the above-explained procedure, and then leakage current measurement and/or DLTS measurement is actually performed.
The two diffused portions adjacent to each other are selected, one of them is connected with the GND, and the other is connected with a measuring instrument 9. At this time, for example, contact is achieved by using a probe to be brought into contact with front surfaces of the respective diffused portions 3 and 3'. As explained above, contact may be achieved through the electrodes formed on the diffused portions 3 and 3' as explained above.

Here, in case of leakage current measurement, a voltage is applied to provide a reverse bias, and a leakage current that is produced at this moment is measured.
Giving an explanation on an example where an N-type dopant is diffused (the diffused portions 3 and 3') into the SOI layer 7 (a P type), a connection side of the measuring instrument has a reverse bias, a depletion layer 10 spreads inside of the SOI layer 7 (near the diffused portion 3), and a leakage current is produced due to an influence of a defect 11 that is present in this depletion layer 10. On the other hand, the GND side (the diffused portion 3' side) is a storage side, and it does not affect a measurement system.
In this manner, a leakage current between the diffused portions 3 and 3' is measured.
Furthermore, a quality of the inside of the SOI wafer 1 (the SOI layer 7) can be evaluated based on a measured value of this leakage current.

Moreover, DLTS measurement can be performed by connecting a DLTS measuring instrument (a capacity meter) in place of the measuring instrument for leakage current measurement, applying a bias in a forward direction and a reverse direction, and measuring a transient time change in an electrostatic capacity.
As explained above, combining DLTS measurement enables specifying a defect type (a metal impurity in particular).
The procedure of the leakage current measurement or the DLTS measurement itself can be carried out like the conventional technology.

Although the present invention will be explained hereinafter in detail based on examples of the present invention, these examples do not restrict the present invention.

### (Example 1)

An SOI wafer was evaluated by using the evaluation method according to the present invention.
As a measurement target wafer, a silicon SOI wafer which was of a P type as a conductivity type and had a diameter of 200 mm and a crystal orientation <100> was used as each of a base wafer and an SOI layer. It is to be noted that boron was used as a dopant that forms the P type. Further, thicknesses of the SOI layer and a BOX film are approximately 13 µm and 1 µm, respectively.
Furthermore, the SOI layer is previously contaminated with Fe on purpose. Wafers having contamination concentrations of 1E11/cm², 5E11/cm², 1E13/cm², and 1E14/cm² were prepared, respectively.

Each SOI wafer was subjected to pyro-oxidation at 1000°C to form an oxide film of 1 µm on a surface of the SOI wafer.
Then, a mask having many 500 µm square patterns arranged thereon at intervals of 1 mm was used to perform photolithography, and etching for forming windows was performed with respect to the oxide film by using Buffered HF to form 500 µm square opening portions in the oxide film at intervals of 1 mm.

Phosphor glass was deposited on this SOI wafer with POCl₃ being used as a raw material, then nitrogen annealing was performed at 1000°C for two hours, and then the phosphor glass was removed by using HF. As a result, PN junctions were formed in the SOI layer. It is to be noted that a diffusion depth of phosphor was approximately 2 µm.

Of two diffused portions adjacent to each other in each sample wafer, one is connected with a GND of a tester whilst the other is connected with a measurement portion, and a reverse bias was applied to measure a leakage current flowing between the diffused portions adjacent to each other. It is to be noted that a tester SC4200 manufactured by Keithley Instruments Inc. and a prober VX-3000 manufactured by Vector Semiconductor Co., LTD. were used as instruments for leakage current measurement in this instance.

FIG. 2 shows a result of Example 1. FIG. 2 depicts a relationship between an Fe concentration obtained from intended contamination and a measured leakage current.
As shown in FIG. 2, a tendency that a leakage current is increased when a contamination concentration based on Fe rises can be confirmed. That is, it can be understood that the leakage current is surely increased as the number of defects or impurities is increased and the leakage current according to the number of, e.g., defects can be measured even if a measurement target is the SOI wafer, thereby the inside of the SOI layer can be evaluated.

### (Example 2)

A sample SOI wafer contaminated for 5E11/cm² with Fe on purpose was evaluated by the same procedure as Example 1 except that a DLTS measuring instrument (DLS-83D manufactured by Semilab) was used as a measuring instrument, measurement data depicted in FIG. 3 was obtained, a peak was identified as Fe from a measurement library (a reference measurement result), and a contamination amount was evaluated as 5E11/cm².
That is, it can be understood that a type and a contamination amount of a contamination metal can be precisely specified based on the evaluation method according to the present invention.

As explained above, according to the method for evaluating an SOI wafer of the present invention, complicated processing does not have to be performed, forming the diffused portions adjacent to each other to form the PN junctions and performing leakage current measurement and/or DLTS measurement in a part between these diffused portions to carry out evaluation can suffice, thereby the SOI wafer can be readily and efficiently evaluated.
In particular, evaluation of the inside of the SOI layer of the SOI wafer that is difficult in the conventional technology can be easily performed, which is very effective.

It is to be noted that the present invention is not restricted to the foregoing embodiment. The foregoing embodiment is just an exemplification, and any example that has substantially the same structure and demonstrates the same functions and effects as the technical concept described in claims of the present invention is included in the technical scope of the present invention.

## Claims

1. A method for evaluating a SOI wafer (1) comprising at least: forming an oxide film (2) on a front surface of a SOI wafer; partially removing the oxide film to form windows (8,8') at two positions; diffusing a dopant having a conductivity type different from a conductivity type of a SOI layer (7) as an evaluation target through the windows at the two positions and forming diffused portions (3,3') in the SOI layer as the evaluation target to form PN junctions with the PN junction depth adjusted so that a desired depth is provided; and performing leakage current measurement and/or Deep Level Transient Spectroscopy measurement in a part between the two diffused portions to evaluate an inside of the SOI layer of the SOI wafer without forming a device.

## Patentansprüche

1. Verfahren zum Bewerten eines SOI-Wafers (1), umfassend mindestens: Bilden eines Oxidfilms (2) auf einer forderen Oberfläche eines SOI-Wafers; teilweise Entfernen des Oxidfilms, um Fenster (8,8') an zwei Positionen zu bilden; Diffundieren eines Dotiermittels, dass einen Leitfähigkeitstyp aufweist, der unterschiedlich ist zu einem Leitfähigkeitstyp einer SOI-Schicht (7), als ein Bewertungsziel durch die Fenster an den zwei Positionen und Bilden von diffundierten Bereichen (3,3') in der SOI Schicht als das Bewertungsziel, um PN-Übergänge zu bilden, wobei die PN-Übergangstiefe eingestellt ist, sodass eine gewünschte Tiefe bereitgestellt ist; und Durchführen von Leckstrommessungen und/oder Kapazitätstransientenspektroskopiemessungen in einem Teil zwischen den beiden diffundierten Bereichen, um ein Inneres der SOI-Schicht auf dem SOI-Wafer zu Bewerten ohne eine Vorrichtung zu bilden.

## Revendications

1. Procédé d'évaluation d'une tranche de SOI (1) comprenant au moins : la formation d'un film d'oxyde (2) sur une surface avant d'une tranche de SOI ; la suppression partielle du film d'oxyde pour former des fenêtres (8, 8') en deux positions ; la diffusion d'un dopant ayant un type de conductivité différent d'un type de conductivité d'une couche de SOI (7) comme une cible d'évaluation à travers les fenêtres aux deux positions et la formation de parties diffusées (3, 3') dans la couche de SOI comme la cible d'évaluation pour former des jonctions PN avec la profondeur des jonctions PN ajustée de manière à ce qu'une profondeur désirée soit obtenue ; et l'exécution d'une mesure de courant de fuite et/ou d'une mesure par spectroscopie capacitive dans une partie entre les deux parties diffusées pour évaluer un intérieur de la couche de SOI de la tranche de SOI sans former un dispositif.
